# FASCICULE DE BREVET EUROPEEN

(11) **EP 3 289 838 B1**
(45) Date de publication et mention de la délivrance du brevet: **20.03.2019**
(21) Numéro de dépôt: 16770547.4
(22) Date de dépôt: 27.04.2016
(51) Int. Cl.: H05K 3/02, B41J 2/475, H05K 3/04

(54) **PROCÉDÉ D'IMPRESSION AU MOYEN DE DEUX LASERS**
DRUCKVERFAHREN MIT ZWEI LASERN
PRINTING METHOD USING TWO LASERS

(30) Priorité: 27.04.2015 FR 1553763
(43) Date de publication de la demande: 07.03.2018
(73) Titulaire: Centre National de la Recherche Scientifique, 75016 Paris (FR); Universite d'Aix Marseille, 13284 Marseille Cedex 07 (FR)
(72) Inventeur: ALLONCLE, Anne Patricia Blanche, 83270 Saint Cyr sur Mer (FR); DELAPORTE, Philippe Christian Maurice, 13008 Marseille (FR)
(74) Mandataire: Gevers & Orès
(86) Numéro de dépôt international: PCT/IB2016/052370
(87) Numéro de publication internationale: WO 2016/174581

(56) Documents cités:
- EP-A1- 0 862 791
- WO-A1-2006/124320
- US-B2- 7 001 467

## Description

L'invention concerne le domaine des techniques d'impression pour l'électronique et plus particulièrement un procédé d'impression par laser.

La réalisation de circuits électroniques sur supports souples est une étape importante pour le développement des objets connectés et de leurs applications, notamment dans les domaines de la santé, de la logistique et de la distribution. La fabrication de ces objets nécessite de nombreuses étapes technologiques et notamment l'impression de structures micrométriques conductrices pour répondre aux problématiques d'interconnexion.

On peut définir deux familles de techniques d'impression pour l'électronique :
- Les technologies à très haut débit issues de l'imprimerie classique telles que la flexogtaphie ou l'offset, qui nécessitent la préparation d'un rouleau gravé ou d'un masque et ne peuvent imprimer qu'un design mais à très grande vitesse.
- Les technologies digitales qui sont beaucoup plus lentes mais qui permettent un contrôle direct du design à imprimer par ordinateur. La plus répandue à ce jour est la technologie jet d'encre, mais on peut mentionner également l'impression par aérosols et l'impression laser.

La technologie jet d'encre est largement utilisée dans les centres de recherche. Elle permet d'imprimer des structures de quelques dizaines de micromètres de large et d'épaisseur inférieure au micron.

Ses principales limitations sont liées au déplacement mécanique des têtes d'impression qui, à grande vitesse, limite la précision et la résolution de l'impression.

Ce procédé ne peut transférer que des encres de faible viscosité et cela limite sa capacité à imprimer des structures conductrices épaisses pour les applications fort courant.

Enfin, le risque de bouchage des têtes d'impression est significatif, le coût des encres est élevé et le procédé requiert une étape de recuit.

En effet, l'impression de lignes conductrices métalliques par jet d'encre passe par le transfert d'encre à nanoparticules d'argent ou de cuivre, suivi par des étapes de recuit pour évaporer le solvant et faire fusionner les particules métalliques entre elles.

La technologie jet d'encre est tout à fait pertinente pour certains types de dépôt, mais ses inconvénients limitent fortement son champ d'application, notamment dans le domaine de la connexion électrique.

Il a également été développé un procédé permettant l'impression par laser de gouttes d'encre à nanoparticule d'argent ou de cuivre. Il s'agit du procédé LIFT pour Laser-Induced Forward Transfer.

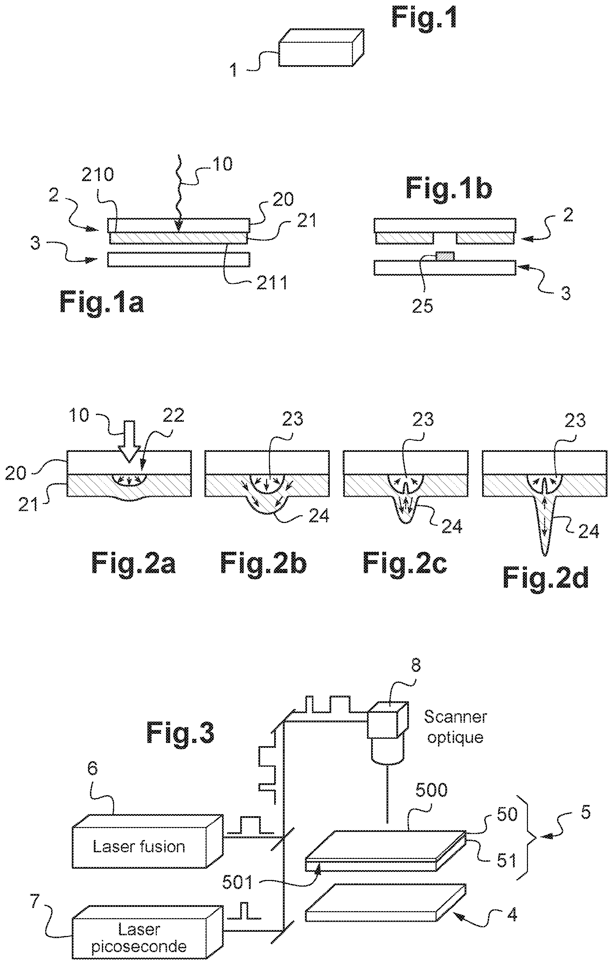

La figure 1 représente schématiquement le principe de ce procédé. Une impulsion laser irradie une couche d'encre à nanoparticules au travers d'un substrat transparent. Ceci induit la formation d'une bulle de cavitation et d'un jet liquide, Ce jet s'étend jusqu'à former une goutte sur le substrat receveur situé en face du film.

Ce procédé LIFT a permet d'imprimer des gouttes de diamètre aussi faible qu'une vingtaine de micromètres et d'épaisseur de quelques centaines de nanomètres. L'utilisation de pates conductrices ou d'encre plus visqueuse est également possible et a permis d'imprimer des structures de plusieurs microns d'épaisseur. La juxtaposition de ces gouttes permet d'imprimer des structures 2D, voir 3D lorsqu'une encre plus visqueuse est utilisée, sur différents types de substrats, notamment polymères et flexibles. L'utilisation d'un laser à fort taux de répétition et d'un système optique adapté a permis d'imprimer des lignes conductrices de 20 µm de large à une vitesse de 4m/s.

Le document US 6 815 015 décrit un procédé de ce type mis en oeuvre avec un substrat dont une face est recouverte d'un fluide rhéologique tel qu'une encre. Le document US7001467 divulgue un procédé utilisant deux laser, mais n'utilise pas de film métallique solide.

Les principaux avantages de ce procédé d'impression par laser par rapport à la technique jet d'encre sont :
- Une meilleure précision car il n'y a pas de mouvement mécanique de la tête d'impression.
- La capacité à imprimer des encres sur une large gamme de viscosité (de 1 mPa.s a 10⁵ mPa.s) et donc des lignes plus épaisses pour la conduction de courants plus intenses.
- La suppression des problèmes de bouchage des têtes d'impression inhérents au procédé jet d'encre.
- La réalisation de lignes plus fines (dont l'épaisseur est inférieure à 15 µm).

Ce procédé ne résout cependant pas encore tous les problèmes.

En particulier, la seule façon de réaliser des lignes conductrices avec une résolution élevée et sans défauts, tels que des débris ou satellites, est de transférer de l'encre à nanoparticules métalliques qui est onéreuse et qui nécessite des étapes de recuit.

Ces étapes sont également un facteur limitant car elles empêchent l'utilisation de substrats à bas coûts qui ne supportent pas des températures supérieures à typiquement 120°.

De plus, ce procédé d'impression laser génère une contrainte supplémentaire qui est la préparation du substrat donneur. Il s'agit de préparer un film uniforme d'encre, d'épaisseur comprise entre quelques micromètres et quelques dizaines de micromètres, dont les propriétés vont varier au cours du temps à cause de l'évaporation du solvant et qui doit donc être continument renouvelé.

Ce procédé peut également être mis en oeuvre avec un substrat transparent dont une face est pourvue d'une couche métrique.

On peut notamment citer le document EP 0 862 791 qui décrit un substrat pourvu d'une couche métallique partitionnée en un réseau de parties intermédiaires. Le faisceau laser dirigé à travers le substrat provoque une fusion rapide de la partie intermédiaire et son dégagement du substrat sous forme d'une gouttelette fondue.

On peut également se référer au document « Micron-scale copper wires printing femtosecond laser-induced forward transfer with automated donor replenishment », Grant-Jacob et al, Optical Materials Express, June 2013, Vol. 3, n° 6 », Ce document rappelle qu'une seule impulsion laser suffit à fondre localement le film métallique pour permettre la génération d'une goutte de métal. Celle-ci se dépose sur un substrat receveur. En se refroidissant, cette goutte va se solidifier et retrouver les propriétés de conduction du métal solide sans que les étapes de recuit soient nécessaires.

Ceci constitue un avantage par rapport à un procédé similaire mis en oeuvre avec un film liquide.

Cependant, comme l'indique l'article mentionné plus haut, il existe des inconvénients liés à ce procédé, notamment l'énergie nécessaire pour éjecter une goutte de métal est suffisamment importante pour éjecter également de nombreux satellites dont il est impossible de s'affranchir. Cette approche induit donc une forte contamination particulaire incompatible avec la plupart des applications en microélectronique.

L'invention a pour objet de proposer un procédé d'impression par laser surmontant les inconvénients des procédés connus en étant facile à mettre en oeuvre, reproductible, en permettant d'obtenir une haute résolution et en évitant les étapes de recuit.

Ainsi, l'invention concerne un procédé d'impression par laser comprenant les étapes suivantes :
(a) la fourniture d'un substrat receveur,
(b) la fourniture d'un substrat cible comprenant un substrat transparent dont une face présente un revêtement constitué d'un film métallique solide,
(c) l'irradiation localisée dudit film au travers dudit substrat transparent au moyen d'un premier laser pour atteindre la température de fusion du métal dans une zone cible dudit film qui est sous forme liquide,
(d) l'irradiation dudit film liquide au travers dudit substrat transparent au moyen d'un deuxième laser sur ladite zone cible définie à l'étape (c), pour former un jet liquide dans ladite zone cible et réaliser son éjection du substrat sous forme de métal fondu,
(e) le dépôt sur le substrat receveur d'une goutte de métal fondu sur une zone de réception définie, ladite goutte se solidifiant lors de son refroidissement.

De façon avantageuse, le premier laser est un laser continu ou à impulsion longue et le deuxième laser est un laser à impulsion courte.

Les étapes (c) et (e) peuvent être répétées pour des zones cibles et des zones de réception successives.

Les étapes (c) à (e) peuvent être répétées pour la même zone cible et la même zone de réception.

Le substrat transparent du substrat cible peut être réalisé en verre ou en quartz.

Le film métallique comprend un métal pouvant être sélectionné dans le groupe constitué de Cu, Au, Ag ou leurs alliages.

L'épaisseur du film métallique est notamment comprise entre 50 nanomètres et 10 micromètres.

L'invention sera mieux comprise et d'autres buts, avantages et caractéristiques de celle-ci apparaîtront plus clairement à la lecture de la description qui suit et qui est faite au regard des dessins annexés sur lesquels :
- la figure 1 représente schématiquement le principe du procédé LIFT appliqué à un substrat cible comprenant un film liquide,
- la figure 2 illustre schématiquement les phénomènes se produisant à l'intérieur du film liquide sous l'effet du laser, lors de la mise en oeuvre du procédé Lift et
- la figure 3 illustre schématiquement un dispositif permettant de mettre en oeuvre le procédé selon l'invention.

En référence à la figure 1, va être décrit le principe du procédé LIFT connu dans l'état de la technique.

Ainsi, la figure la illustre une source d'énergie laser 1 susceptible de générer une énergie laser 10.

Elle illustre également un substrat cible 2 comportant un substrat transparent 20 et un revêtement 21 constitué par un film liquide.

La figure 1a illustre également un substrat receveur 3.

Le substrat cible 2 est situé entré la source d'énergie laser 1 et le substrat receveur 3.

Par ailleurs, le revêtement 21 est réalisé sur la face du substrat 20 qui est en regard du substrat receveur 3. Ainsi, le revêtement 21 comporte une face 210 en contact avec le substrat 20 et une face 211 en vis-à-vis du substrat receveur 3.

Ce revêtement 21 peut être constitué par une encre à nanoparticules d'argent ou de cuivre.

Une fois le substrat cible 2 et le substrat receveur 3 positionnés comme illustré sur la figure 1a, le revêtement 21 est irradié au moyen de la source d'énergie laser 1 .

Dans cette phase d'irradiation, l'énergie laser 10 passe à travers le substrat 20 transparent au laser pour atteindre une zone cible définie du revêtement 21.

L'énergie laser 10 est suffisante pour chauffer localement un petit volume du fluide présent dans le revêtement 21.

Il est maintenant fait référence à la figure 2a qui illustre comment une goutte de fluide est alors formée.

La figure 2a montre l'énergie laser 10 qui passe à travers le substrat transparent 20 et la création de vapeur 22 dans une région cible définie du film 21.

Cette quantité de fluide évaporé créé une surpression dans cette zone cible qui conduit à pousser, hors du substrat 20, le fluide non évaporé qui est présent dans cette même zone cible.

Les figures 2b à 2d illustrent schématiquement les étapes de formation d'une bulle de cavitation 23 et d'un jet liquide 24.

Ce jet liquide s'étend de plus en plus, jusqu'à former une goutte 25 sur une zone de réception définie du substrat receveur 3 (figure 1b).

Une étape de recuit est ensuite réalisée.

Il est maintenant fait référence à la figure 3 qui illustre schématiquement un dispositif permettant de mettre en oeuvre le procédé selon l'invention.

Le procédé nécessite tout d'abord de fournir un substrat receveur 4 et un substrat cible 5, ce substrat cible comprenant un substrat transparent 50 dont une face 501 présente un revêtement 51, ici constitué d'un film métallique solide.

Comme l'illustre la figure 3, le substrat receveur et le substrat cible sont positionnés de telle sorte que le revêtement 51 soit en regard du substrat receveur 4.

Le dispositif comporte quant à lui un premier laser 6 et un deuxième laser 7, dont le déplacement des faisceaux est contrôlé par un système optique tel qu'un scanner optique 8.

Comme l'illustre la figure 3, le scanner 8 est positionné de façon à pouvoir transmettre une énergie laser, provenant du premier laser 6 ou du deuxième laser 7, sur la face 500 du substrat 50 opposé au film 51.

Le procédé selon l'invention consiste tout d'abord à irradier localement le film 51 au travers du substrat transparent 50 au moyen du premier laser 6, sur une zone cible définie.

Ce premier laser est du type continu ou à impulsions longues. Il s'agit notamment d'un laser à diode infrarouge continu dont le faisceau peut être modulé temporellement.

Dans la zone cible irradiée, le film atteint la température de fusion du métal et se trouve ainsi sous forme liquide sur le support transparent 50.

Lorsque la zone irradiée est sous forme liquide, le dispositif est commandé de façon à ce que le deuxième laser 7 irradie cette même zone cible au travers du substrat transparent 50.

Ce deuxième laser 7 est du type à impulsions courtes. A titre d'exemple, ce deuxième laser est un laser picoseconde infrarouge, un laser nanoseconde ou femtoseconde.

Il induit la formation d'un jet liquide et le dépôt d'une goutte de métal fondu sur le substrat receveur 4, comme cela a été décrit précédemment au regard des figures 1 et 2.

Ces étapes ne seront pas décrites en détail puisque le film de métal fondu se comporte alors comme un film liquide. Cette étape du procédé est donc réalisée comme avec le procédé Lift décrit en référence aux figures 1 et 2.

Une fois déposée sur le substrat receveur 4, la goutte de métal fondu se refroidit et donc se solidifie. Elle retrouve alors les propriétés de conduction du métal solide sans que des étapes de recuit soient nécessaires.

Ainsi, le procédé selon l'invention permet d'associer les avantages du transfert en phase liquide et en phase solide, en utilisant deux lasers différents.

Ce procédé permet de réaliser des lignes de connexion à partir de matériaux peu onéreux et en supprimant l'étape de recuit qui limite l'utilisation de substrats receveurs à bas coûts.

Il permet donc de réduire de façon significative les coûts de fabrication en permettant l'utilisation de substrat moins onéreux et en supprimant l'étape de recuit. Il permet également d'obtenir une résolution comparable à celle obtenue avec des films liquides, cette résolution étant donc meilleure que celle obtenue avec le procédé d'impression par jet d'encre. De plus, il permet d'éviter la génération de débris comme cela est le cas lors d'impression en phase solide avec une seule impulsion laser.

Ce procédé peut être appliqué à la réalisation de circuits souples à afficheurs mais il peut également être utilisé dans le domaine du photovoltaïque pour réaliser des électrodes de collecte.

Dans ce type d'application, il convient de souligner qu'il n'existe aujourd'hui pas de solution pour imprimer des lignes de connexion de plusieurs micromètres d'épaisseur, nécessaires pour un fort courant, avec un procédé adaptable au produit et sans contact, pour respecter la fragilité des couches minces.

Ce procédé ouvre également la possibilité d'imprimer tout type de matériau et d'atteindre des dimensions nanométriques. En effet, la dimension des pixels imprimés est contrôlée par la fluence du laser mais surtout par l'épaisseur du film liquide. Le procédé d'impression selon l'invention qui met en oeuvre une double impulsion laser permettra la réalisation de films liquides d'épaisseur nanométrique et donc l'impression de pixels de quelques dizaines de nanomètres de diamètre. Ceci ouvre la voie vers la réalisation de structures plasmoniques et de cristaux photoniques.

Les signes de référence insérés après les caractéristiques techniques figurant dans les revendications ont pour seul but de faciliter la compréhension de ces dernières et ne sauraient en limiter la portée.

## Revendications

1. Procédé d'impression par laser comprenant les étapes suivantes :
(a) la fourniture d'un substrat receveur (4),
(b) la fourniture d'un substrat cible (5) comprenant un substrat transparent (50) dont une face présente un revêtement (51) constitué d'un film métallique solide,
(c) l'irradiation localisée dudit film (51) au travers dudit substrat transparent (50) au moyen d'un premier laser (6) pour atteindre la température de fusion du métal dans une zone cible dudit film qui est sous forme liquide,
(d) l'irradiation dudit film liquide au travers dudit substrat transparent au moyen d'un deuxième laser sur ladite zone cible définie à l'étape (c), pour former un jet liquide dans ladite zone cible et réaliser son éjection du substrat sous forme de métal fondu,
(e) le dépôt sur le substrat receveur d'une goutte de métal fondu sur une zone de réception définie, ladite goutte se solidifiant lors de son refroidissement.

2. Procédé selon la revendication 1 dans lequel le premier laser est un laser continu ou à impulsion longue.

3. Procédé selon la revendication 1 ou 2 dans lequel le deuxième laser est un laser à impulsion courte.

4. Procédé selon l'une des revendications 1 à 3, dans lequel les étapes (c) à (e) sont répétées pour des zones cibles et des zones de réception successives.

5. Procédé selon l'une des revendications 1 à 3, dans lequel les étapes (c) à (e) sont répétées pour les mêmes zone cible et zone de réception.

6. Procédé selon l'une des revendications 1 à 5 dans lequel le substrat transparent du substrat cible est réalisé en verre ou en quartz.

7. Procédé selon l'une des revendications 1 à 6 dans lequel le film métallique comprend un métal sélectionné dans le groupe constitué de Cu, Au, Ag ou leurs alliages.

8. Procédé selon l'une des revendications 1 à 7 dans lequel l'épaisseur du film métallique est comprise entre 50 nanomètres et 10 micromètres.

## Patentansprüche

1. Laserdruckverfahren, umfassend die folgenden Schritte:
(a) das Bereitstellen eines Aufnahmesubstrats (4),
(b) das Bereitstellen eines Zielsubstrats (5), das ein transparentes Substrat (50) umfasst, von dem eine Seite eine Beschichtung (51) aufweist, die aus einem festen Metallfilm besteht,
(c) das lokale Bestrahlen des Films (51) durch das transparente Substrat (50) hindurch mittels eines ersten Lasers (6), um die Fusionstemperatur des Metalls in einer Zielzone des Films zu erreichen, der in flüssiger Form vorliegt,
(d) das Bestrahlen des flüssigen Films durch das transparente Substrat hindurch mittels eines zweiten Lasers auf der Zielzone, die im Schritt (c) definiert ist, um einen flüssigen Strahl in der Zielzone zu bilden und seinen Ausstoß aus dem Substrat in Form von geschmolzenem Metall auszuführen,
(e) das Ablagern eines Tropfens geschmolzenen Metalls auf dem Aufnahmesubstrat auf einer definierten Aufnahmezone, wobei der Tropfen sich während seines Erkaltens verfestigt.

2. Verfahren nach Anspruch 1, wobei der erste Laser ein Dauerstrich- oder Langpulslaser ist.

3. Verfahren nach Anspruch 1 oder 2, wobei der zweite Laser ein Kurzpulslaser ist.

4. Verfahren nach einem der Ansprüche 1 bis 3, wobei die Schritte (c) bis (e) für aufeinanderfolgende Zielzonen und Aufnahmezonen wiederholt werden.

5. Verfahren nach einem der Ansprüche 1 bis 3, wobei die Schritte (c) bis (e) für die gleiche Zielzone und Aufnahmezone wiederholt werden.

6. Verfahren nach einem der Ansprüche 1 bis 5, wobei das transparente Substrat des Zielsubstrats aus Glas oder aus Quarz hergestellt ist.

7. Verfahren nach einem der Ansprüche 1 bis 6, wobei der Metallfilm ein Metall umfasst, ausgewählt aus der Gruppe, bestehend aus Cu, Au, Ag oder ihren Legierungen.

8. Verfahren nach einem der Ansprüche 1 bis 7, wobei die Dicke des Metallfilms zwischen 50 Nanometern und 10 Mikrometern beträgt.

## Claims

1. Laser printing method comprising the following steps:
(a) providing a receiving substrate (4),
(b) providing a target substrate (5) comprising a transparent substrate (50), one face of which presents a coating (51) made of a solid metal film,
(c) locally irradiating said film (51) through said transparent substrate (50) by means of a first laser (6) to reach the melting point of the metal in a target zone of said film that is in liquid form,
(d) irradiating said liquid film through the transparent substrate by means of a second laser on said target zone defined in step (c), to form a liquid jet in said target zone and to perform its ejection from the substrate in the form of molten metal,
(e) depositing a drop of molten metal on a defined receiving zone of the receiving substrate, said drop solidifying as it cools.

2. Method according to claim 1, wherein the first laser is a continuous laser or a long pulse laser.

3. Method according to claim 1 or 2, wherein the second laser is a short pulse laser.

4. Method according to one of claims 1 to 3, wherein steps (c) to (e) are repeated for successive target zones and receiving zones.

5. Method according to one of claims 1 to 3, wherein steps (c) to (e) are repeated for the same target zone and receiving zone.

6. Method according to one of claims 1 to 5, wherein the transparent substrate of the target substrate is made of glass or quartz.

7. Method according to one of claims 1 to 6, wherein the metal film comprises a metal selected from the group comprising Cu, Au, Ag or the alloys thereof.

8. Method according to one of claims 1 to 7, wherein the thickness of the metal film is comprised between 50 nanometres and 10 micrometres.
